# DEMANDE DE BREVET EUROPEEN

(11) **EP 4 836 660 A1**
(43) Date de publication de la demande: **04.11.2026**
(21) Numéro de dépôt: 26173704.3
(22) Date de dépôt: 21.04.2026
(51) Int. Cl.: H10K 85/50, H10K 30/40, H10K 71/40, H10K 71/12

(54) **DISPOSITIF OPTOELECTRONIQUE COMPRENANT UNE COUCHE DE PEROVSKITE HYBRIDE ORGANIQUE-INORGANIQUE**

(30) Priorité: 22.04.2025 FR 2504247
(71) Demandeur: Commissariat à l'Energie Atomique et aux Energies Alternatives, 75015 Paris (FR)
(72) Inventeur: GOMES, Thomas, 38054 GRENOBLE CEDEX 09 (FR); CROS, Stéphane, 38054 GRENOBLE CEDEX 09 (FR)
(74) Mandataire: Cabinet Beaumont

(57) **Abrégé**

Dispositif optoélectronique comprenant successivement un substrat (110), une couche de type p (130) et une couche active (140) en pérovskite de formule CsₓFA₁₋ₓPbI_{3-y-z}Br_{y}Cl_{z}, avec z>0, la couche active (140) ayant une première face (141) en contact avec la couche de type p (130) et une deuxième face (142), la couche active (140) présentant un premier gradient en chlore croissant depuis une partie centrale de la couche active (140) jusqu'à la première face (141).

## Description

### Domaine technique

La présente description concerne de façon générale le domaine des dispositifs optoélectroniques, et plus particulièrement, des dispositifs optoélectroniques comprenant une couche en pérovskite, notamment les cellules photovoltaïques simple jonction ou les cellules photovoltaïques tandem silicium/pérovskite.

### Technique antérieure

Les cellules photovoltaïques à base de pérovskite comprennent une couche active en pérovskite disposée entre une couche de transport des trous (HTL pour 'Hole Transport Layer') et une couche en transport des électrons (ETL pour 'Electron Transport Layer'). La couche active absorbe la lumière et génère des paires électron-trou. La couche HTL permet d'extraire les trous générés par la couche en pérovksite et de les transporter vers une première électrode et la couche ETL permet d'extraire les électrons générés par la couche en pérovksite et de les transporter vers une deuxième électrode. La couche active joue un rôle essentiel dans les performances de la cellule photovoltaïque.

Cependant, la stabilité et les performances de la couche active en pérovskite peuvent être diminuées en raison de plusieurs facteurs, et notamment, en raison de la présence des défauts dans la couche en pérovskite et de la migration ionique au sein de la couche.

Bien qu'une photogénération efficace soit possible avec un film de pérovskite comportant des défauts, ces défauts ont tout de même un effet sur les performances de la cellule, notamment en créant des sites favorisant les recombinaisons non radiatives de porteurs de charge, induisant ainsi une baisse de la tension de circuit ouvert V_{oc}.

De plus, les défauts forment des zones préférentielles pour la dégradation de la couche de pérovskite en piégeant des charges, ce qui, d'une part, induit une réactivité accrue de la pérovskite avec l'eau [1] et à l'oxygène [2], et d'autre part, conduit à la formation d'espèces favorisant la dégradation sous illumination, comme l'iode élémentaire résultant de la capture de charges par l'iodure interstitiel [3].

Les défauts problématiques sont situés en premier lieu aux interfaces entre la pérovskite et les couches de transport de charge (principalement avec la couche de transport d'électrons pour une architecture p-i-n dans laquelle la couche pérovskite « i » est déposée sur la couche HTL « p »)), puis dans les joints de grains, avec les défauts dans le volume ('*bulk*'*)* de la couche.

La migration ionique est l'autre point clé des études sur la dégradation. La pérovskite étant un cristal ionique, elle est composée d'un mélange complexe d'ions, dont certains diffusent particulièrement facilement dans le réseau cristallin. Cette diffusion est facilitée par la présence de défauts tels que les lacunes, qui forment des chemins de diffusion préférentiels. Elle a aussi pour effet de propager les effets des défauts à tout le film, par exemple en créant un gradient de concentration en iode, ce qui participe au mécanisme de la dégradation de la pérovskite sous illumination [3].

La migration ionique est aussi associée à d'autres voies de dégradation. L'iode est particulièrement connu pour diffuser à travers les couches de transport et jusqu'aux électrodes métalliques, et à réagir avec l'argent, par exemple, produisant de l'iodure d'argent isolant [4]. La migration des halogènes est également problématique à cause d'un phénomène de ségrégation de phase, lors duquel des zones du matériau s'enrichissent en iode, ce qui réduit le gap et crée des pièges pour les charges [5], augmentant les recombinaisons et diminuant la tension de circuit ouvert V_{oc} de la cellule photovoltaïque.

Afin de résoudre ces problèmes, il est possible de passiver les défauts présents dans le volume ('bulk') des pérovskites hybrides 3D.

Pour des cellules solaires à base de pérovskite halogénée hybride, une des voies les plus prometteuses est d'utiliser le CsCl comme agent passivant, ce qui permet de stabiliser la pérovskite. Les procédés utilisés consistent généralement à ajouter le CsCl dans le mélange de précurseurs de la pérovskite, de déposer la solution, par exemple par dépôt à la tournette (*'spin coating')* sur la couche sous-jacente puis de la faire cristalliser par traitement thermique.

Par exemple, dans l'article de Gostishchev et al. [6], le procédé de fabrication d'une cellule photovoltaïque de type p-i-n à base de pérovskite hybride de formule CsFAPbI₃ comprend les étapes suivantes :
- déposer une solution contenant les précurseurs de la couche de pérovskite (CsI, FAI et PbI₂) et du CsCl sur un substrat recouvert par une couche de NiOx, par dépôt à la tournette,
- réaliser un premier traitement thermique à 85 °C (1 min) puis un second traitement thermique à 105 °C (30 min).

Selon un autre procédé, une couche de pérovskite 3D hybride est également passivée dans son volume par CsCl, hors d'un empilement [7]. Le procédé comprend les étapes suivantes :
- déposer une solution contenant les précurseurs (formamidine, CsI, PbI₂ et CsCl) et un additif (un composé formamidine avec un anion acétate ou formate et/ou un composé comprenant du césium et anion acétate ou formate) sur un substrat, par exemple, par dépôt à la tournette,
- réaliser un traitement thermique à une température comprise entre 120 et 180°C pendant 15 à 30 min pour évaporer le solvant et cristalliser la pérovskite.

Cependant, malgré ces avancées récentes, les performances des cellules photovoltaïques peuvent encore être améliorées.

### Résumé de l'invention

Il existe un besoin d'avoir un dispositif optoélectronique comprenant une couche de pérovskite hybride présentant de bonnes performances et une bonne stabilité.

Ce but est atteint par un dispositif optoélectronique comprenant successivement un substrat, une couche conductrice de type p et une couche active en pérovskite de formule CsₓFA₁₋ₓPbI_{3-y-z}Br_{yC}l_{zr} avec z>0, la couche active ayant une première face en contact avec la couche conductrice de type p et une deuxième face, la couche active présentant un premier gradient en chlore croissant depuis une partie centrale de la couche active jusqu'à la première face.

Selon un mode de réalisation particulier, le premier gradient en chlore est présent sur une épaisseur d'au moins 10 nm.

Selon un mode de réalisation particulier, la couche active présente un deuxième gradient en chlore croissant depuis la partie centrale de la couche active jusqu'à la deuxième face, le deuxième gradient en chlore étant, de préférence, présent sur une épaisseur d'au moins 10 nm.

Selon un mode de réalisation particulier, la deuxième face de la couche active en contact avec une couche conductrice de type n.

Selon un mode de réalisation particulier, la concentration en chlore est au moins 25% et, de préférence, au moins 30% plus élevée sur la première face que dans la partie centrale de la couche active.

Selon un mode de réalisation particulier, 0.05 < x < 0.25 et/ou 0.30 < y < 1.20 et/ou 0 < z <0.30, et de préférence, 0.18 < x < 0.25 et/ou 0.30 < y ≤ 0.60 et/ou 0 < z < 0.1.

Selon un mode de réalisation particulier, une couche en Cs₂PbI₂Cl₂ est formée sur la première face de la couche active et est en contact avec la couche conductrice de type p.

Selon un mode de réalisation particulier, la couche conductrice de type p est une couche de 2PACz.

Ce but est également atteint par un procédé de fabrication d'un dispositif optoélectronique comprenant les étapes suivantes :
- déposer, par exemple par enduction centrifuge, sur un substrat recouvert par une couche de type p, de préférence en 2PACz, une solution comprenant des précurseurs d'une couche active en pérovskite et un additif,
   les précurseurs étant formés d'un mélange de PbI₂, PbBr₂, FAI et CsI, et l'additif étant CsCl,
- réaliser un premier traitement thermique à une température T1 comprise entre 80 et 120 °C pendant une durée d'au moins 5 min, et de préférence d'au moins 15 min,
- réaliser un deuxième traitement thermique à une température T2 comprise entre 130°C et 180°C pendant une durée comprise entre 1 et 60 min, de préférence entre 1 et 20 min, et encore plus préférentiellement, entre 5 et 15 min,
moyennant quoi on obtient une couche active en pérovskite de formule CsₓFA₁₋ₓPbI_{3-y-z}Br_{y}Cl_{z}, avec z>0, la couche active présente un premier gradient en chlore croissant depuis une partie centrale de la couche active jusqu'à une première face en contact avec la couche conductrice de type p.

Selon un mode de réalisation particulier, la température T1 est comprise entre 95 et 105 °C et/ou la température T2 est comprise entre 135 et 170 °C.

Selon un mode de réalisation particulier, la concentration en additif CsCl est comprise entre 3.75%mol et 7.5%mol par rapport à la concentration en plomb dans les précurseurs.

Selon un mode de réalisation particulier, l'additif est ajouté en mélange avec du PbI₂, le PbI₂ étant en excès par rapport à l'additif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et en coupe, une cellule photovoltaïque simple jonction à base de pérovskite selon un mode de réalisation particulier de l'invention ;
la figure 2 représente, de manière schématique et en coupe, une cellule photovoltaïque tandem à base de pérovskite selon un autre mode de réalisation particulier de l'invention ;
la figure 3A, la figure 3B, la figure 3C et la figure 3D sont des graphiques représentant, respectivement, l'évolution du rendement P, de la tension de circuit ouvert V_{oc}, du courant de court-circuit J_{sc} et du facteur de forme FF, sous stress lumineux, pour différentes cellules photovoltaïques à base de pérovskite :
   - cellule 'Ref1' : une cellule ayant été soumise à un recuit de 1h à 100°C (procédé standard de cristallisation) selon un premier exemple comparatif ;
   - cellule 'Ref2' : une cellule pour laquelle un mélange de CsCl 7.5% et de PbI₂ a été ajouté aux précurseurs, la cellule a été soumise au même recuit de 1h à 100°C que 'Ref1' mais n'a pas été soumise à une étape de post-recuit, selon un deuxième exemple comparatif ;
   - cellule 'C1' : une cellule pour laquelle un mélange de CsCl 7.5% et de PbI₂ a été ajouté aux précurseurs, la cellule ayant été soumise à une étape de post recuit de 10 minutes à 135°C à la suite du recuit de 1h à 100°C, selon un mode de réalisation particulier de l'invention ;
   - cellule 'C2' : une cellule pour laquelle un mélange de CsCl 7.5% et de PbI₂ a été ajouté aux précurseurs, la cellule ayant été soumise à une étape de post recuit de 10 minutes à 160°C à la suite du recuit de 1h à 100°C, selon un autre mode de réalisation particulier de l'invention ;

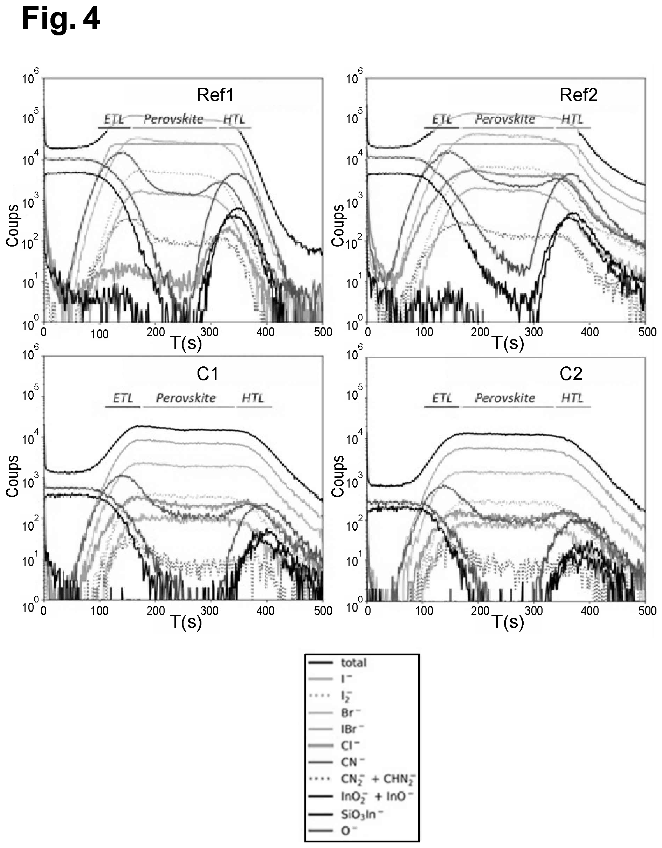

la figure 4 représente plusieurs profils de composition obtenus par ToF-SIMS pour les cellules Ref1, Ref2, C1 et C2 décrites précédemment ;

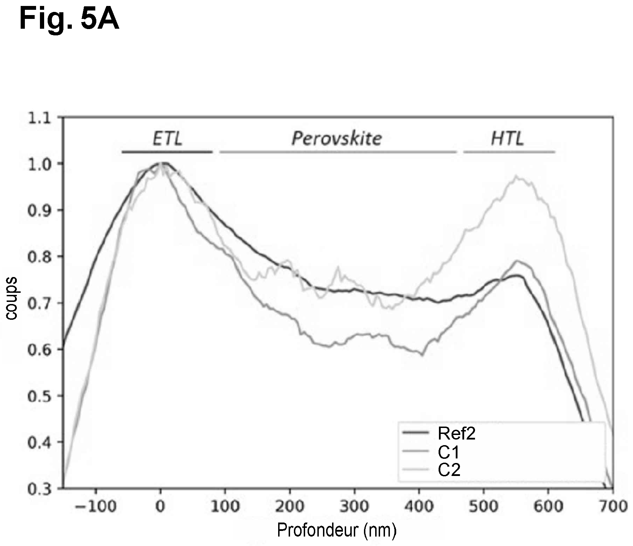

la figure 5A est un graphique représentant des profils de composition en chlore obtenus par ToF-SIMS, avec lissage et normalisation, pour les cellules Ref2, C1 et C2 décrites précédemment, la profondeur d'analyse est estimée à partir du temps d'abrasion ('sputter time') et de l'épaisseur totale de la couche estimée à 550 nm ;

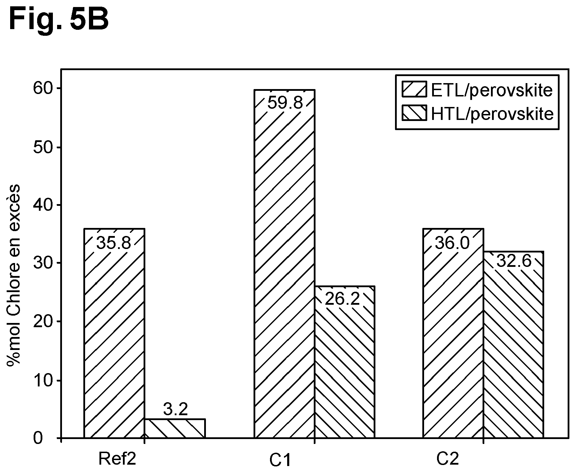

la figure 5B est un graphique représentant l'excès de chlore aux interfaces ETL/pérovskite et HTL/pérovskite par rapport au centre de la couche (les interfaces sont déterminées par les maxima locaux de comptages ; la valeur de concentration en Cl dans le centre de la couche est prise en moyennant le nombre de comptages sur une zone d'une largeur de 150 nm centrée sur la position équidistante des maxima à l'ETL et à l'HTL) pour les cellules Ref2, C1 et C2 décrites précédemment ;

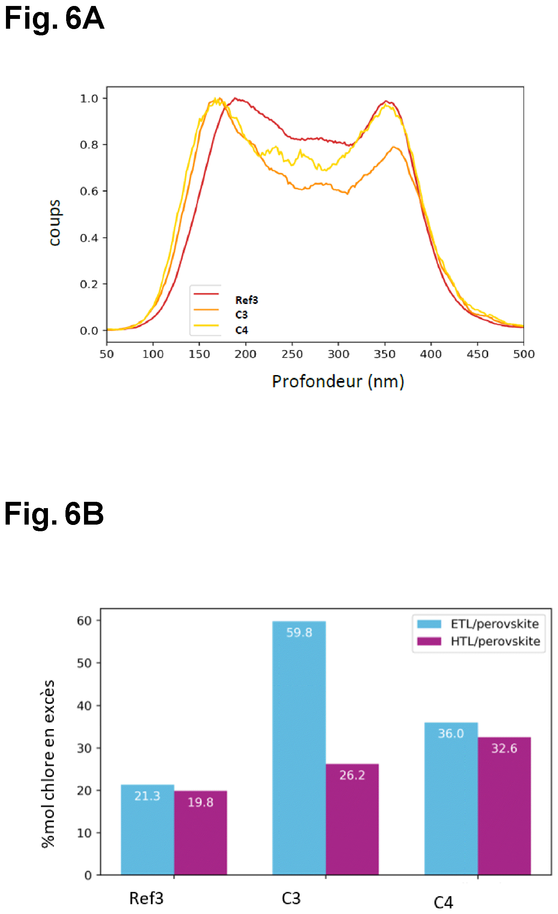

la figure 6A est un graphique représentant des profils de composition en chlore obtenus par ToF-SIMS, avec lissage et normalisation, la profondeur d'analyse est estimée à partir du temps d'abrasion ('sputter time') et de l'épaisseur totale de la couche estimée à 550 nm, pour :
   - cellule 'Ref3' : une cellule pour laquelle un mélange de CsCl 7.5% et de PbI₂ a été ajouté aux précurseurs, la cellule a été soumise à un recuit de 1h à 100°C que 'Ref1' mais n'a pas été soumise à une étape de post-recuit, selon un autre exemple comparatif ;
   - cellule 'C3' : une cellule pour laquelle un mélange de CsCl 7.5% et de PbI₂ a été ajouté aux précurseurs, la cellule ayant été soumise à une étape de post recuit de 10 minutes à 135°C à la suite du recuit de 1h à 100°C, selon un autre mode de réalisation particulier de l'invention ;
   - cellule 'C4' : une cellule pour laquelle un mélange de CsCl 7.5% et de PbI₂ a été ajouté aux précurseurs, la cellule ayant été soumise à une étape de post recuit de 10 minutes à 160°C à la suite du recuit de 1h à 100°C, selon un autre mode de réalisation particulier de l'invention ;
la figure 6B est un graphique représentant l'excès de chlore aux interfaces ETL/pérovskite et HTL/pérovskite par rapport au centre de la couche (les interfaces sont déterminées par les maxima locaux de comptages ; la valeur de concentration en C3 dans le centre de la couche est prise en moyennant le nombre de comptages sur une zone d'une largeur de 150 nm centrée sur la position équidistante des maxima à l'ETL et à l'HTL) pour les cellules Ref3, C3 et C4 décrites précédemment.

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par transparent, on entend que la structure ou l'élément considéré a une transmittance supérieure ou égale à 70 %, de préférence supérieure ou égale à 80% et encore plus préférentiellement supérieure ou égale à 90%. La transmittance représente l'intensité lumineuse traversant l'élément ou la structure sur le spectre du visible. Elle peut être mesurée par spectrométrie UV-Vis-IR. La transmittance du spectre du visible correspond à la transmittance pour des longueurs d'ondes comprise entre 350 et 800 nm.

Par compris entre X et Y, on entend que les bornes X et Y sont incluses.

Le dispositif optoélectronique qui va être décrit plus en détail par la suite comprend au moins une couche 3D en pérovskite (notée PK) 140, et plus particulièrement une couche 3D en pérovskite 140 halogénée hybride organique-inorganique contenant du césium Cs, du formamidinium FA, du plomb Pb, de l'iode I et du brome Br.

Le dispositif optoélectronique 100 peut être un dispositif choisi parmi :
- un dispositif photovoltaïque : une cellule solaire simple jonction, une cellule solaire en configuration tandem (Silicium / pérovskite, pérovskite / pérovskite, CIGS / pérovskite) ou, de manière plus générale, une cellule solaire multijonction (SI/PK/PK),
- un capteur de lumière comprenant en outre des pérovskites, quantum dots (par exemple PbS), II-VI (par exemple CdTe), CIGS, semiconducteurs couches minces, OLED, ou semiconducteurs organiques,
- un émetteur de lumière : pérovskites, quantum dots (par exemple PbS), II-VI (par exemple CdTe), CIGS, semiconducteurs couches minces, OLED, ou semiconducteurs organiques,
- un dispositif photocatalytique,
- un dispositif pour la photo-électrolyse.

Le dispositif est, de préférence, une cellule photovoltaïque, mais il pourrait s'agir d'un autre dispositif optoélectronique.

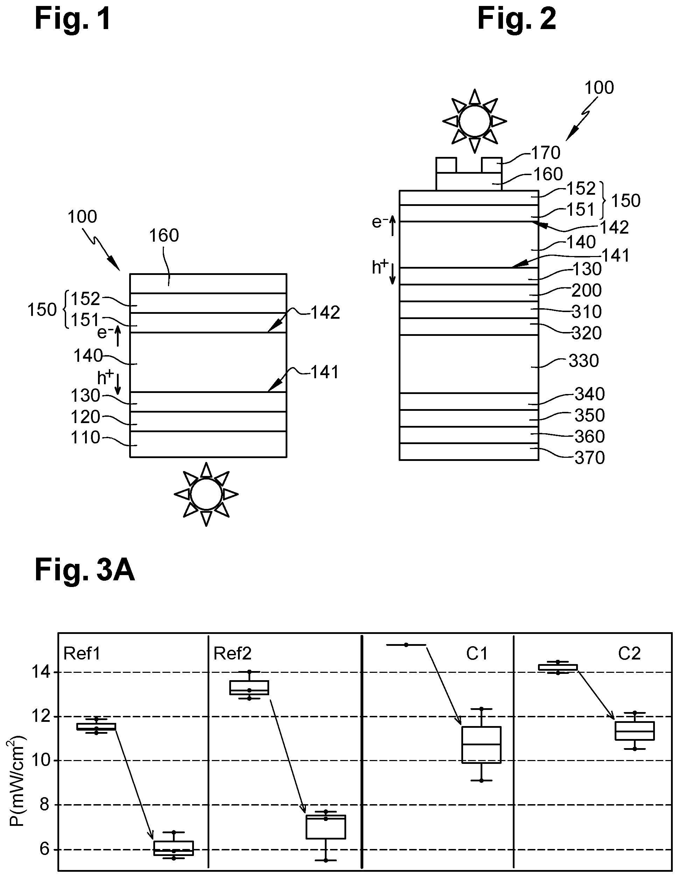

Comme représenté sur les figures 1 et 2, le dispositif comprend successivement un substrat 110, une couche conductrice de type p 130 et une couche active 140 en pérovskite hybride organique-inorganique.

La couche active est une couche comprenant de formule CsₓFA₁₋ₓPbI_{3-y-z}Br_{y}Cl_{z}, avec z>0. La couche active 140, en plus de contenir du césium Cs, du formamidinium FA, du plomb Pb, de l'iode I et du brome Br, contient en outre du chlore. La présence de chlore permet d'améliorer la stabilité et les performances de la cellule.

Plus particulièrement, le matériau pérovskite peut être un composé de formule CsₓFA₁₋ₓPbI_{3-y-z}Br_{y}Cl_{z} avec x > 0, z > 0 et y ≥ 0 (de préférence y>0).

De préférence, 0.05 < x < 0.25 et/ou 0.30 < y < 1.20 et/ou 0 < z < 0.30. Encore plus préférentiellement, 0.18 < x < 0.25 et/ou 0.30 < y ≤ 0.60 et/ou 0 < z < 0.1.

Une telle gamme pour x permet d'avoir du césium tout en évitant de la déstabiliser.

Une telle gamme de y permet d'incorporer suffisamment de brome et ainsi avoir un gap adapté aux cellules tandems sans déstabiliser la couche. La présence de brome dans la couche active augmente le gap de la cellule. La présence de brome est particulièrement avantageuse dans le cas d'une cellule tandem.

Une telle gamme de z permet de passiver dans le volume et en surface la couche active tout en évitant de trop modifier les propriétés de la couche active.

La couche active en pérovskite a, par exemple, une épaisseur comprise entre 400 nm et 1 µm, de préférence entre 400 et 700 µm, et encore plus préférentiellement entre 500 et 600 nm.

La couche active 140 comprend une première face 141 (ou première face principale) et une deuxième face 142 (ou deuxième face principale). Les deux faces sont parallèles ou sensiblement parallèles entre elles.

Entre la première face 141 et la deuxième face 142, se situe la partie centrale (ou centre) de la couche active 140.

Par « partie centrale » ou « centre » de la couche, on entend une épaisseur d'environ 150 nm d'épaisseur située à égale distance des faces supérieure et inférieure de la couche de pérovskite.

La première face 141 est en contact avec la couche conductrice de type p 130. La deuxième face 142 est en contact, par exemple, avec une couche conductrice de type n 150.

La couche active 140 présente un premier gradient en chlore croissant depuis la partie centrale de la couche active 140 jusqu'à la première face 141. La concentration en chlore est minimale au centre de la couche et la concentration en chlore atteint un premier maximum au niveau de la première face 141 de la couche active 140 à l'interface pérovskite/HTL. La concentration en chlore est ainsi croissante depuis le centre vers l'interface pérovskite/HTL.

De préférence, la couche active 140 présente un deuxième gradient en chlore croissant depuis la partie centrale de la couche active 140 jusqu'à la deuxième face 142. La concentration en chlore est minimale au centre de la couche et la concentration en chlore atteint un deuxième maximum au niveau de la deuxième face 142 de la couche active 140 à l'interface pérovksite/ETL. La concentration en chlore est croissante depuis le centre vers l'interface pérovskite/ETL. Le premier maximum est supérieur au deuxième maximum.

De préférence, le gradient de concentration en chlore a lieu sur une épaisseur d'au moins 10 nm, par exemple entre 10 et 20 nm, de la couche active 140.

Une accumulation de chlore est observée aux interfaces entre la couche pérovskite 140 et les couches ETL et HTL.

A l'interface pérovskite/ETL (i.e. au niveau de la deuxième face 142), l'excès de chlore est compris entre 15% et 75% par rapport au « centre » de la couche pérovskite 140.

A l'interface pérovskite/HTL (i.e. au niveau de la première face 141), l'excès de chlore est compris entre 10% et 40% par rapport au « centre » de la couche pérovskite 140.

Une phase de Ruddlesden-Popper ou « pérovskite 2D » inorganique Cs₂PbI₂Cl₂ peut également être formée au niveau de de l'interface pérovskite/ETL ou de l'interface pérovskite/HTL ou au niveau des deux interfaces.

L'interface entre la couche active 140 en pérovskite et la couche conductrice de type p 130 (HTL), présentant une forte concentration en chlore, est très prometteuse puisqu'elle forme ainsi une couche de passivation au niveau de la couche conductrice de type p 130, ce qui permet d'utiliser un plus large choix de matériaux pour la couche conductrice de type p 130.

La couche conductrice de type p 130 est, de préférence, une couche autoassemblée (SAM), et encore plus préférentiellement une couche en carbazole ancrée sur la couche inférieure par un groupement acide phosphonique ou methoxysilane. Ces groupements jouent un rôle non seulement pour l'ancrage et la stabilité de la couche mais aussi pour la fonction de sélectivité des trous. En particulier, il peut s'agir d'une couche en 2PACz (acide (2-(9H-carbazol-9-yl)éthyl)phosphonique)).

L'utilisation d'une couche 130 en 2PACz donne des performances électriques initiales records et offrent des possibilités de dépôt à l'échelle industrielle relativement facile (notamment par voie physique, par exemple par évaporation thermique) et peu coûteuse, car utilisant peu de matériau. Grâce à la passivation par le chlore, des couches de transport de trous 130 en 2PACz peuvent être utilisées. En effet, en l'absence d'une telle passivation, ce matériau n'offre qu'une stabilité limitée sous illumination, avec notamment des pertes de tension de circuit ouvert (V_{oc}) marquées sous illumination continue.

La couche conductrice de type p 130 pourrait être en un autre matériau, par exemple, choisi parmi les autres monocouches auto-assemblées : MeO-2PACz, Me-4PACz, etc. Il peut également s'agir d'une couche d'oxyde, et notamment d'oxyde de nickel, comme par exemple NiOₓ et NiOₓ. Ces matériaux peuvent être utilisés en combinaison avec un agent passivant.

La couche de type n 150 peut être un bicouche comprenant une couche 151 de C₆₀ (fullerène) et une couche de 152 BCP (bathocuproïne). Le PCBM ([6,6]-phényl-C61-butanoate de méthyle) peut être également utilisé à la place du fullerène. En substitut au BCP, il est possible d'utiliser de l'oxyde d'étain (SnO₂).

Par exemple, la cellule solaire simple jonction p-i-n comprend successivement depuis la face soumise au rayonnement lumineux (figure 1) :
- le substrat 110, de préférence transparent, par exemple en verre,
- la première électrode 120 dite électrode inférieure, de préférence transparente, par exemple une couche en oxyde transparent conducteur (TCO pour 'Transparent conductive Oxide'), notamment en oxyde d'indium et d'étain (ou ITO pour 'Indium Tin Oxide'),
- une couche conductrice de type p 130 (aussi appelée couche en transport de trous),
- la couche active en pérovskite 140,
- une couche conductrice de type n 150 (aussi appelée couche en transport d'électrons), pouvant être formé d'un bicouche,
- une deuxième électrode 160 dite électrode supérieure en métal, par exemple en argent ou en aluminium.

Des contacts métalliques, par exemple en Cr/Au, sont formés sur le substrat 110 (non représentés). Ils peuvent être déportés.

L'éclairement se fait à travers le substrat 110.

Il pourrait également s'agir d'une cellule simple jonction sur silicium avec un substrat en silicium, l'éclairement étant alors réalisé par la face supérieure (et non pas à travers le substrat).

La cellule 100 solaire tandem silicium pérovskite de type p-i-n est une structure comprenant deux sous-cellules empilées l'une sur l'autre. La sous-cellule supérieure est une sous-cellule en pérovskite tandis que la sous-cellule inférieure est en silicium, notamment il s'agit d'une sous-cellule à hétérojonction de silicium (figure 2).

Les cellules photovoltaïques tandem pérovskite sur silicium permet de maximiser l'efficacité de conversion de l'énergie solaire.

Les deux sous-cellules peuvent être séparées par une couche intermédiaire 200 électroniquement conductrice ou semi-conductrice et transparente au rayonnement électromagnétique. Elle peut comporter voire être constituée de TCO (oxydes conducteurs transparents) choisis parmi, par exemple, l'ITO (oxyde d'indium-étain), l'AZO (oxyde d'aluminium-zinc), l'IZO (oxyde d'indium-zinc).

La sous-cellule à base de pérovskite comprend successivement depuis la face supérieure face exposée au soleil :
- une électrode dite électrode supérieure 160 de préférence transparente,
- une couche conductrice de type n 150 (aussi appelée couche en transport d'électrons (ETL pour 'Electrons Transport Layer'), pouvant être sous la forme d'un bicouche,
- une couche active en pérovskite 140,
- une couche conductrice de type p 130 (HTL).

La sous-cellule à hétérojonction de silicium comprend, par exemple, depuis la couche intermédiaire 200 ou depuis la sous-cellule à base de pérovskite :
- une couche en silicium amorphe dopé n 310,
- de préférence une couche à base de silicium amorphe intrinsèque 320 servant de couche en passivation,
- un substrat en silicium cristallin dopé n 330,
- de préférence, une couche à base de silicium amorphe intrinsèque 340 servant de couche en passivation,
- une couche en silicium amorphe dopé p 350,
- une électrode 360, de préférence transparente.

Des contacts métalliques 370, par exemple en Ag ou Cr/Au, sont formés sur l'électrode 360 de la sous-cellule à base de silicium et d'autres contacts métalliques 170 peuvent être formés sur l'électrode supérieure 160 de la sous-cellule à base de pérovskite. Ils peuvent être déportés au niveau de la face éclairée.

L'éclairement d'un dispositif tandem Si/PK est réalisé à partir de la sous-cellule à base de pérovskite.

Les matériaux précédemment décrits pour la cellule pérovskite simple jonction peuvent être utilisés pour la sous-cellule à base de pérovskite.

Nous allons maintenant décrire le procédé de fabrication du dispositif optoélectronique 100.

Le procédé comprend les étapes suivantes :
- déposer, par exemple par enduction centrifuge, sur un support comprenant un substrat 110 recouvert par une couche conductrice de type p 130, une solution contenant les précurseurs de la couche active 140 en pérovskite et du CsCl,
- réaliser un premier traitement thermique à une température T1 comprise entre 80 et 120 °C pendant une durée t1 d'au moins 5 min,
- réaliser un deuxième traitement thermique à une température T2 comprise entre 130°C et 180°C pendant une durée t2 comprise entre 1 et 60 min.

Le premier traitement thermique permet de faire cristalliser la couche active 140 en pérovskite. Lors du premier traitement thermique, la température T1 est maintenue pendant une durée t1 d'au moins 5 min, de préférence d'au moins 15 min, encore plus préférentiellement d'au moins 20 min, par exemple 60 min.

Le deuxième traitement thermique est un post-recuit à haute température. Il joue un rôle clé pour « activer » l'effet de l'additif. Le deuxième traitement thermique permet d'« activer » l'additif sans soumettre la couche active 140 pérovskite hybride à un stress thermique trop important afin de ne pas la dégrader. Lors du deuxième traitement thermique, l'additif (CsCl) agit pour passiver les défauts ponctuels dans la couche de pérovskite 140 et/ou réagir avec le PbI₂ présent dans la couche de pérovskite 140 pour former la phase de pérovskite 2D inorganique Cs₂PbI₂Cl₂.

De préférence, la deuxième température T2 est comprise entre 135°C et 170 °C, encore plus préférentiellement entre 150°C et 170°.

La deuxième température T2 est maintenue pendant une durée d'au moins 1 min, de préférence d'au moins 5 min, encore plus préférentiellement d'au moins 10 min. Par exemple, la durée t2 est comprise entre 1 et 20 min, et encore plus préférentiellement, entre 5 et 15 min.

Le deuxième traitement thermique, réalisé à une température T2 supérieure à la température T1 du premier traitement thermique.

Entre le premier traitement thermique et le deuxième traitement thermique, le procédé peut comprendre une étape de refroidissement au cours de laquelle la température descend jusqu'à une température inférieure à la température T1. Par exemple, il est possible de refroidir la couche pérovskite jusqu'à la température ambiante (typiquement entre 20 et 25°C).

Selon un autre mode de réalisation, il n'y a pas d'étape de refroidissement et, entre le premier traitement thermique et le deuxième traitement thermique, la couche de pérovskite est à une température comprise entre T1 et T2.

La solution déposée sur la couche conductrice de type p 130 contient les précurseurs de la couche active 130 ainsi que l'additif CsCl.

Les précurseurs sont, par exemple, un mélange de PbI₂, PbBr₂, FAI, CsI.

L'additif CsCl représente, par exemple, entre 3.75 et 7.5%mol par rapport au plomb présent dans les précurseurs.

Par exemple, pour une couche active 140 ayant été soumise à un traitement de passivation avec 7,5%mol de CsCl, on obtient une pérovskite avec x = 0.22, y = 0.48, z = 0.02.

Pour une couche active 140 ayant été soumise à un traitement de passivation avec 3,75%mol de CsCl, on obtient une pérovskite avec x = 0.19, y = 0.50, z = 0.01.

A titre de comparaison, pour une cellule standard non passivée avec CsCl, on a x = 0.16 et y = 0.51.

De préférence, l'additif CsCl est ajouté en mélange avec du PbI₂ supplémentaire. L'excès de PbI₂ peut être ajouté stœchiométrique (1 PbI₂ : 2 CsCl dans la composition de la pérovskite 2D) par rapport à la quantité de CsCl. Cet ajout de PbI₂ permet d'apporter le matériau nécessaire à la formation de la pérovskite 2D sans affecter directement la composition de la pérovskite 3D.

La solution de précurseurs contient en outre un ou plusieurs solvants organiques. Par exemple, il s'agit de DMF (N,N-diméthylformamide ) et/ou de DMSO (diméthylsulfoxyde).

La solution est, par exemple, déposée par dépôt à la tournette, mais elle pourrait être utilisée par une autre technique de dépôt par voie liquide.

La solution peut être déposée en présence d'un ou plusieurs anti-solvants. Un anti-solvant est un solvant dans lequel la pérovskite est peu soluble. L'anti-solvant est injecté pendant le dépôt pour faire précipiter rapidement la pérovskite et améliorer l'homogénéité du film par rapport à une cristallisation « libre ». L'anti-solvant peut être par exemple du chlorobenzène ou de l'acétate d'éthyle.

Le protocole est simple à mettre en œuvre, avec l'introduction directe de l'additif dans la solution contenant les précurseurs de la couche de pérovskite 140 et l'application d'un post-recuit à haute température. Un tel procédé évite de déposer des couches de passivation sur la couche de pérovskite 140.

Les couches de pérovskites obtenues 140 présentent de meilleures performances. Il est ainsi possible d'améliorer significativement le comportement en vieillissement des cellules, avec une diminution des pertes sur tous les paramètres photovoltaïques.

Notamment, il a été observé des résultats de stabilité améliorée sans perte de V_{oc} après application d'un stress assez fort, sous illumination continue de 72h en circuit ouvert. Cette amélioration est attribuée au traitement en volume par CsCl+PbI₂ et la mise en œuvre du post-recuit, qui permet de modifier la composition de la pérovskite à l'interface pérovskite-2PACz, en forçant l'accumulation de l'additif à cette interface. Cette amélioration permet de profiter des avantages de l'usage du 2PACz et d'une pérovskite 3D hybride sans compromettre la stabilité de la cellule.

La mise en œuvre d'une solution de passivation adaptée à l'usage d'une pérovskite 3D hybride ainsi qu'à celui d'une couche HTL de type 2PACz est particulièrement intéressante sur le plan des performances électriques de la cellule ainsi que sur celui de la mise en œuvre à l'échelle industrielle.

### Exemples illustratifs et non limitatifs

Dans ce premier exemple, la couche de pérovskite halogénée hybride (Cs,FA)Pb(I,Br)₂ est déposée sur une couche HTL en 2PACz.

La couche de pérovskite halogénée hybride est préparée à partir d'une solution comprenant les précurseurs (PbI₂, PbBr₂, FAI, CsI), des additifs (CsCl,PbI₂) et un mélange de solvants (DMF et de DMSO).

La concentration de l'additif CsCl dans la solution de pérovskite est comprise entre 3,75%mol et 7,5%mol de la concentration de Pb dans la pérovskite (prenant en compte les deux précurseurs PbI₂ et PbBr₂) . Un excès de PbI₂ est également ajouté, stœchiométrique (1 PbI₂ : 2 CsCl) par rapport à la quantité de CsCl.

La solution est déposée par enduction centrifuge ('*spin coating*') sur la couche HTL en présence d'un anti-solvant sur le substrat de la cellule. Puis, la couche de pérovskite est soumise à un premier traitement thermique à 100°C pendant 60 min sur une plaque chauffante sous atmosphère inerte.

Un deuxième traitement thermique (appelé post-recuit) est réalisé à des températures comprises entre 135°C et 160°C pendant une durée allant de 1 min à 60 min, toujours sous atmosphère inerte. Un premier échantillon (noté C1) a été préparé avec un post-recuit à 135°C et un deuxième échantillon (noté C2) a été préparé avec un post-recuit à 160°C.

A titre de comparaison, un premier échantillon comparatif (noté Ref1) a été préparé sans ajouter d'additif à la solution de précurseurs et en mettant en œuvre un seul traitement thermique à 100°C pendant 1h et un deuxième échantillon comparatif (noté Ref2) a été préparé en utilisant les additifs et en mettant en œuvre un deuxième traitement thermique à 100°C.

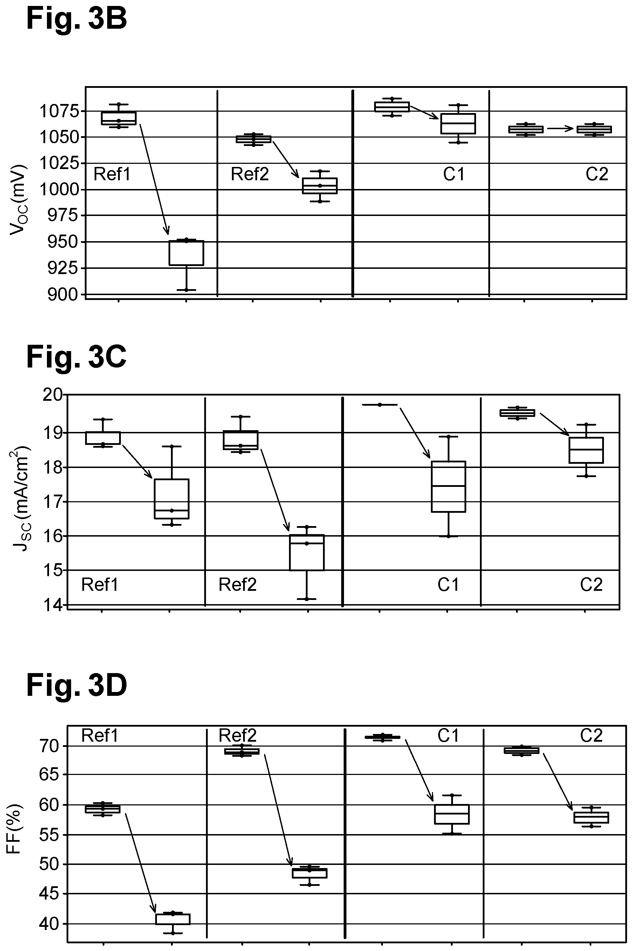

Les cellules photovoltaïques ont été caractérisées sous stress lumineux avant et après vieillissement Les paramètres photovoltaïques sont le rendement P (figure 3A), la tension de circuit ouvert V_{oc} (figure 3B), le courant de court-circuit J_{sc} (figure 3C) et le facteur de forme FF (figure 3D). Les flèches indiquent le vieillissement.

Les résultats sont répertoriés dans le tableau suivant.

**[Table 1]**

| | P (mW/cm²) | J_{sc} (mA/cm²) | V_{oc} (mV) | FF (%) | ΔP (%) | ΔJ_{sc} (%) | ΔV_{oc} (%) | ΔFF (%) |
|---|---|---|---|---|---|---|---|---|
| Ref1 | 11.46 | 18.66 | 1065.0 | 59.3 | -48.1 | -10.2 | -10.8 | -29.7 |
| Ref1 - 1sun 72h | 5.94 | 16.75 | 950.5 | 41.7 | | | | |
| Ref2 | 13.19 | 18.63 | 1048.4 | 69.0 | -43.8 | -15.1 | -4.2 | -28.7 |
| Ref2 - 1sun 72h | 7.41 | 15.82 | 1004.4 | 49.2 | | | | |
| C1 | 15.25 | 19.82 | 1079.4 | 71.5 | -29.7 | -11.9 | -1.5 | -18.2 |
| C1 - 1sun 72h | 10.72 | 17.46 | 1063.6 | 58.5 | | | | |
| C2 | 14.22 | 19.60 | 1058.4 | 69.3 | -20.3 | -5.6 | +0.1 | -16.3 |
| C2 - 1sun 72h | 11.33 | 18.51 | 1059.0 | 58.0 | | | | |

On observe un gain net de stabilité par rapport à la cellule sans additif (Ref1), mais aussi par rapport à la cellule avec additif CsCl mais sans post-recuit (Ref2), ce qui met en évidence l'importance de cette étape de post-recuit.

Les cellules préparées avec l'additif et ayant été soumise à une étape de post-recuit présentent de meilleures performances. Ceci est encore plus visible pour la cellule C2 avec le post-recuit à 160°C : on observe des pertes faibles de J_{sc} (-5,6%) par rapport aux autres conditions (-10% au moins) et un V_{oc} stable (+0,1%). Après vieillissement, la cellule C2 est celle qui perd le moins en rendement (avec une perte de puissance de -20,3%) par rapport à -48,1% pour la référence Ref1 non traitée.

Ces résultats confirment que le procédé mettant en œuvre à la fois des additifs et un post-recuit permet d'améliorer les performances des cellules pérovskites, et d'améliorer significativement le comportement en vieillissement, avec des diminutions des pertes sur tous les paramètres photovoltaïques.

Des études de compositions ont été réalisées par ToF-SIMS (Spectroscopie de Masse d'Ions Secondaires par Temps de Vol), permettant d'analyser la répartition des différents éléments de la couche (Figure 4, Figures 5A et 5B). Ceci confirme l'influence de l'additif et du post-recuit sur le matériau pérovskite.

Dans la référence Ref1, sans additif, le chlore est à l'état de traces (contamination extérieure (~10¹ coups) et présence de chlore résiduel provenant de la sous-cellule silicium (~10² coups)). La concentration est environ 1000 fois plus faible dans le film de référence que dans les films traités (~10⁴ à signal total égal).

Lorsqu'un deuxième traitement thermique n'est pas mis en œuvre, un excès de chlore peut être observé aux interfaces, dû au rejet du chlore hors de la couche de pérovskite.

L'accumulation de chlore à l'interface entre la pérovskite et le silicium correspond au chlore résiduel lié aux traitements chimiques réalisés sur la sous-cellule de silicium. L'effet de ce chlore résiduel est considéré comme négligeable par rapport à l'additif, puisque le signal du à ce chlore résiduel est un ordre de grandeur plus faible que le signal dans les échantillons traités par CsCl. De plus, les effets observés sont également visibles sur d'autres types de substrats de silicium sans ce traitement.

Pour la référence avec le traitement CsCl et sans recuit haute température (Ref2), le chlore est bien détecté, avec une distribution quasiment constante dans la couche de pérovskite, malgré une accumulation près des interfaces, surtout du côté de l'ETL (avant de pénétrer dans le film de pérovskite), avec un excès de chlore par rapport au centre de 35.8%.

Pour les échantillons C1 et C2, avec les post-recuits, le profil de chlore se « creuse », avec une différence amplifiée entre le centre de la couche et les interfaces, où l'additif semble s'accumuler. Dans le cas du recuit à 160°C, la concentration de chlore est presque identique près de l'HTL (excès de 32.6%) et près de l'ETL (excès de 36.0%), ce qui n'est pas le cas dans les autres conditions. Ceci pourrait expliquer le comportement particulier des échantillons ayant subi ce recuit à 160°C, et leur meilleur comportement en stabilité, même avec une couche HTL 130 en 2PACz.

En effet, le CsCl s'accumulant à l'interface pérovskite-2PACz semble permettre de passiver les défauts apparaissant à cette interface lors de l'exposition au stress lumineux, évitant la perte de V_{oc} liée à l'apparition de ces défauts. De plus, la potentielle formation de la pérovskite 2D (bien que non démontrée ici) pourrait aussi expliquer cet effet bénéfique. D'une part, la formation de la phase 2D spécifiquement à l'interface semble possible, car l'effet observé à 160°C semble correspondre à la condition où la quantité maximale de CsCl est présente à l'interface et à l'application d'une haute température, qui sont deux conditions nécessaires à l'apparition de la phase 2D Cs₂PbI₂Cl₂. D'autre part, l'effet de la phase 2D, en plus de la possible passivation directe des défauts, pourrait également être dû à l'amélioration de l'alignement énergétique des couches de l'empilement.

D'autres essais (figure 6A et figure 6B) confirment également que la mise en œuvre d'un deuxième traitement thermique (ou post-recuit) permet de contrôler l'excès de chlore aux interfaces. Sans deuxième traitement thermique, on observe un léger et symétrique excès de chlore aux interfaces. Avec un deuxième traitement thermique, l'excès de chlore augmente aux interfaces. Par exemple, avec un deuxième traitement thermique à 135°C, l'excès de chlore est asymétrique aux interfaces et avec un deuxième traitement thermique à plus haute température (160°C), l'excès de chlore aux interfaces est symétrique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### REFERENCES

[1] N. Ahn et al., Nat. Commun. 2016, 7, 13422.
[2] S. Zhang, G. Han, Prog. Energy 2020, 2, 022002.
[3] S. G. Motti et al., Nat. Photonics 2019, 13, 532.
[4] J. Li et al., Adv. Energy Mater. 2017, 7, 1602922.
[5] E. T. Hoke et al., Chem. Sci. 2014, 6, 613.
[6] P. Gostishchev et al., Sol. RRL 2023, 7, 2200941.
[7] CN117794334 B

## Revendications

1. Procédé de fabrication d'un dispositif optoélectronique comprenant les étapes suivantes :
- déposer, par exemple par enduction centrifuge, sur un substrat (110) recouvert par une couche de type p (130), de préférence en 2PACz, une solution comprenant des précurseurs d'une couche active (140) en pérovskite et un additif,
les précurseurs étant formés d'un mélange de PbI₂, PbBr₂, FAI et CsI, et l'additif étant CsCl,
- réaliser un premier traitement thermique à une température T1 comprise entre 80 et 120 °C pendant une durée d'au moins 5 min, et de préférence d'au moins 15 min,
- réaliser un deuxième traitement thermique à une température T2 comprise entre 130°C et 180°C pendant une durée comprise entre 1 et 60 min, de préférence entre 1 et 20 min, et encore plus préférentiellement, entre 5 et 15 min,
moyennant quoi on obtient une couche active (140) en pérovskite de formule CsₓFA₁₋ₓPbI_{3-y-z}Br_{y}Cl_{z}, avec z>0, la couche active (140) présente un premier gradient en chlore croissant depuis une partie centrale de la couche active (140) jusqu'à une première face (141) en contact avec la couche conductrice de type p (130).

2. Procédé selon la revendication précédente, dans lequel la température T1 est comprise entre 95 et 105 °C et/ou dans lequel la température T2 est comprise entre 135 et 170 °C.

3. Procédé selon l'une des revendications précédentes, dans lequel la concentration en additif CsCl est comprise entre 3.75%mol et 7.5%mol par rapport à la concentration en plomb dans les précurseurs.

4. Procédé selon l'une des revendications précédentes, dans lequel l'additif est ajouté en mélange avec du PbI₂, le PbI₂ étant en excès par rapport à l'additif.

5. Dispositif optoélectronique comprenant successivement un substrat (110), une couche conductrice de type p (130) et une couche active (140) en pérovskite de formule CsₓFA₁₋ₓPbI_{3-y-z}Br_{y}Cl_{z}, avec z>0, la couche active (140) ayant une première face (141) en contact avec la couche conductrice de type p (130) et une deuxième face (142), la couche active (140) présentant un premier gradient en chlore croissant depuis une partie centrale de la couche active (140) jusqu'à la première face (141).

6. Dispositif optoélectronique selon la revendication 5, dans lequel le premier gradient en chlore est présent sur une épaisseur d'au moins 10 nm.

7. Dispositif selon la revendication 5 ou la revendication 6, dans lequel la couche active (140) présente un deuxième gradient en chlore croissant depuis la partie centrale de la couche active (140) jusqu'à la deuxième face (142), le deuxième gradient en chlore étant, de préférence, présent sur une épaisseur d'au moins 10 nm.

8. Dispositif selon la revendication 7, dans lequel la concentration en chlore atteint un premier maximum au niveau de la première face (141) de la couche active (140) et la concentration en chlore atteint un deuxième maximum au niveau de la deuxième face (142) de la couche active (140), le premier maximum étant supérieur au deuxième maximum.

9. Dispositif selon la revendication 7 ou la revendication 8, dans lequel la concentration en chlore est entre 15 et 75%, de préférence entre 30 et 75%, plus élevée sur la deuxième face (142) que dans la partie centrale de la couche active (140) et dans lequel la concentration en chlore est entre 10 et 40% plus élevée sur la première face (141) que dans la partie centrale de la couche active (140).

10. Dispositif selon l'une des revendications 5 à 9, dans lequel la deuxième face (142) de la couche active (140) en contact avec une couche conductrice de type n.

11. Dispositif selon l'une des revendications 5 à 10, dans lequel la concentration en chlore est au moins 25% et, de préférence, au moins 30% plus élevée sur la première face (141) que dans la partie centrale de la couche active (140).

12. Dispositif selon l'une des revendications 5 à 11, dans lequel 0.05 < x < 0.25 et/ou 0.30 < y < 1.20 et/ou 0 < z <0.30, et de préférence, 0.18 < x < 0.25 et/ou 0.30 < y ≤ 0.60 et/ou 0 < z < 0.1.

13. Dispositif selon la revendication précédente, dans lequel 0 < z < 0.1.

14. Dispositif selon l'une des revendications 5 à 13, dans lequel une couche en Cs₂PbI₂Cl₂ est formée sur la première face (141) de la couche active (140) et est en contact avec la couche conductrice de type p (130).

15. Dispositif selon l'une des revendications 5 à 14, dans lequel la couche conductrice de type p (130) est une couche de 2PACz.
